# EUROPÄISCHE PATENTSCHRIFT

(11) **EP 1 473 976 B1**
(45) Veröffentlichungstag und Bekanntmachung des Hinweises auf die Patenterteilung: **29.08.2007**
(21) Anmeldenummer: 04002919.1
(22) Anmeldetag: 10.02.2004
(51) Int. Cl.: H05B 37/02, G08C 19/02, G08C 19/36

(54) **Schnittstelle für Digitale- und Netzspannungssignale und Verfahren zur Auslegung solch einer Schnittstelle**
Interface for digital and power line control signals and method for dimensioning such an interface
Interface pour signaux de commande digitaux ou signaux de commande par le réseau et méthode de dimensionnement d' un tel interface

(30) Priorität: 30.04.2003 DE 10319514
(43) Veröffentlichungstag der Anmeldung: 03.11.2004
(73) Patentinhaber: TridonicAtco GmbH & Co. KG, 6850 Dornbirn (AT)
(72) Erfinder: Böckle, Reinhard, 6841 Mäder (AT)
(74) Vertreter: Rupp, Christian

(56) Entgegenhaltungen:
- EP-A- 0 714 224
- WO-A-01/52607
- DE-A- 3 729 204
- DE-A- 4 126 588
- DE-A- 19 757 295
- US-A- 5 339 009

## Beschreibung

Die vorliegende Erfindung bezieht sich auf eine Schnittstelle mit zwei eingangsseitigen Anschlüssen, wobei die Schnittstelle dazu ausgelegt ist, mit einem elektronischen Gerät (beispielsweise einem elektronischen Vorschaltgerät, EVG) verbunden zu werden. Dabei können an die beiden eingangsseitigen Anschlüsse der Schnittstelle wahlweise Digitalsignale oder auch Netzspannungssignale von einem Taster oder Schalter angelegt werden.

Die Schnittstelle muss also in der Lage s18ein, sowohl Digitalsignale mit Spannungswerten beispielsweise zwischen - 10 Volt und +30 Volt einerseits und Netzspannungssignale andererseits verwertbar an ein angeschlossenes Gerät weiterzugeben, wobei die Schnittstelle auch bei einem lange andauernden Anliegen eines Netzspannungssignals keinen Schaden nehmen darf.

Aus der DE 41 26 588 A1 ist eine Schaltung bekannt, bei der ein Taster mit einem Niederspannungskreis verbunden ist, wobei der Niederspannungskreis über einen Optokoppler mit einem auf Netzspannung liegenden Leistungssteuerkreis verbunden ist, der ein Leuchtmittel betreibt. Der einzig zulässige Signaltyp ist dabei eine getaktete Niederspannung und nur über diese Taktung der Niederspannung lässt sich eine Ansteuerung der Leuchtmittel erreichen. Als Schutzmaßnahme für Überspannungen der Niederspannung ist ein PTC-Glied vorgesehen.

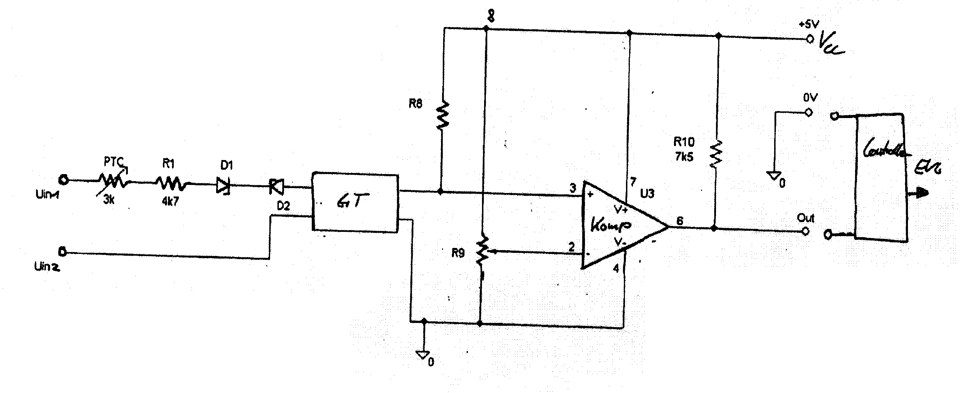

Auch der deutschen Patentanmeldung 197 08 784 ist ein elektronisches Vorschaltgerät bekannt, das (in der Ausführungsform gemäss Figur 7) eine Schnittstellenvorrichtung aufweist. Diese Schnittstellenvorrichtung kann dabei über Tastersignale bzw. Schaltersignale wie auch über digitale Steuersignale angesteuert werden. Im Falle eines angeschlossenen Tasters kann dann ein angeschlossenes elektronisches Vorschaltgerät durch einen (kurzen bzw. langen) Tastendruck ein- bzw. ausgeschaltet werden. In gleicher Weise ist jedoch auch ein DSI (Digital Signal Interface)-Betrieb möglich, bei dem bestimmte digitale Befehle beispielsweise Sollwerte für eine Helligkeitsregelung etc. übermitteln.

Es ist Aufgabe der vorliegenden Erfindung, die aus der DE 197 08 784 bekannte Schnittstelle technisch derart zu vereinfachen, dass eine Kosteneinsparung gegeben ist. Dabei sollen natürlich die Anforderungen hinsichtlich der Festigkeit der Schnittstelle gegenüber Spannungsspitzen bzw. einem dauernden Anliegen der Netzspannung erfüllt werden.

Erfindungsgemäss wird diese Aufgabe durch die Merkmale der unabhängigen Ansprüche gelöst. Die abhängigen Ansprüche bilden den zentralen Gedanken der Erfindung in besonders vorteilhafter Weise weiter.

Gemäß einem ersten Aspekt der vorliegenden Erfindung ist also eine Schnittstelle zur Ansteuerung eines elektronischen Geräts, wie beispielsweise eines Lampenbetriebsgeräts oder eines LED-Betriebsgeräts vorgeschlagen, wobei die Schnittstelle zwei eingangsseitige Anschlüsse aufweist, an die wahlweise ein Digitalsignal oder ein Netzspannungssignal angelegt werden kann. Die beiden eingangsseitigen Anschlüsse sind dabei mit einem Potentialtrennungselement, wie beispielsweise einem Optokoppler oder einem Übertrager verbunden. Erfindungsgemäss ist zwischen einem der beiden eingangsseitigen Anschlüsse und dem Potentialtrennungselement ein Ohm'scher Widerstand sowie ein PTC-Element, d.h. ein Element, dessen Ohm'scher Widerstand mit steigender Temperatur zunimmt, geschaltet. Diese Serienschaltung hat durch ihr zeitliches Widerstandsverhalten zu gewährleisten, dass die Schnittstelle einerseits die beiden Signaltypen verwertbar weitergibt und andereseits selbst keinen Schaden nimmt.

Die Serienschaltung bestehend aus dem Ohm'schen Widerstand sowie dem PTC-Element ist dabei derart bemessen, dass bei Anliegen einer Spannung entsprechend einem Digitalsignal durch die Schnittstelle ein Strom fließt, der die Ansprechschwelle des Optokopplers überschreitet.

Andererseits ist die Serienschaltung bestehend aus dem Ohm'schen Widerstand und dem PTC-Element derart bemessen, dass bei Anliegen einer Spannung entsprechend einem Taster- oder Schaltersignal (Netzspannung) im stationären (warmen) Zustand des PTC-Elements der Strom durch den Optokoppler nicht den maximal für ihn zulässigen Dauerstrom überschreitet.

Zu der Serienschaltung bestehend aus dem Ohm'schen Widerstand und dem PTC-Element kann weiterhin wenigstens eine Zenerdiode in Serie geschaltet sein.

Die Schnittstelle kann einen Komparator zur Diskriminierung des Spannungswerts des an den eingangsseitigen Anschlüssen anliegenden Signals aufweisen, wobei die Komparatorschwelle von dem durch die Schnittstelle fließenden Strom abhängen kann.

Die Schnittstelle kann für einen bidirektionalen Datenverkehr ausgelegt sein. Das heisst, es können nicht Daten (von einem Bus im Fall von Digitaldaten bzw. von einem Taster oder Schalter im Fall eines Netzspannungssignals) durch die Schnittstelle an ein angeschlossenes elektronisches Gerät hin übermittelt werden, sondern es können auch Daten von dem angeschlossenen elektronischen Gerät mittels der Schnittstelle beispielsweise an eine Busleitung ausgegeben werden.

Die Erfindung bezieht sich auch auf ein Verfahren zur Auslegung einer Schnittstelle.

Gemäss einem weiteren Aspekt der vorliegenden Erfindung ist ein Lampen- oder LED-Betriebsgerät vorgesehen, das eine derartige Schnittstelle aufweist und somit wahlweise über Digitaldaten oder Taster- oder Schaltersignale (Netzspannungssignale) angesteuert werden kann.

Weitere Merkmale, Vorteile und Eigenschaften der vorliegenden Erfindung werden nunmehr Bezug nehmend auf die einzige Figur der begleitenden Zeichnungen näher erläutert.

Die einzige Figur zeigt schematisch eine Schnittstellenvorrichtung gemäss der vorliegenden Erfindung.

Wie in der Figur ersichtlich, weist die Schnittstellenvorrichtung dabei zwei eingangsseitige Anschlüsse U_{IN1}, U_{IN2} auf. An diese eingangsseitigen Anschlüsse U_{IN1}, U_{IN2} können wahlweise Digitalsignale beispielsweise mit einer maximalen Amplitude zwischen 20 und 30 Volt und Netzspannungsignale von einem Taster oder Schalter angelegt werden.

Die Schnittstellenvorrichtung bereitet diese an den eingangsseitigen Anschlüssen U_{IN1}, U_{IN2} anliegenden Signale derart auf, dass unabhängig von der Natur der anliegenden Signale an einem ausgangsseitigen Anschluss OUT ein Digitalsignal ausgegeben wird, dessen logischer Wert dem des an den eingangsseitigen Anschlüssen U_{IN1}, U_{IN2} anliegenden Signals entspricht. Das von der Schnittstellenvorrichtung ausgegebene digitale Logiksignal kann dann beispielsweise von einem folgenden Controller ausgewertet werden, der wiederum ein angeschlossenes elektronisches Gerät, wie beispielsweise ein Lampenbetriebsgerät (z. B. elektronisches Vorschaltgerät EVG) oder LED-Betriebsgerät entsprechend ansteuert.

Die Eingangsseite (Anschlüsse U_{IN1}, U_{IN2}) und die Ausgangsseite (OUT) der erfindungsgemässen Schnittstellenvorrichtung sind voneinander galvanisch getrennt, was schematisch durch das Element GT dargestellt ist. Als Element GT zur galvanischen Trennung (Potentialtrennung) kommen dabei beispielsweise Optokoppler, Übertrager und Pegelversatzstufen infrage.

Erfindungsgemäss ist einer der eingangsseitigen Anschlüsse U_{IN2} direkt mit diesem Element zur galvanischen Trennung GT verbunden. Zwischen dem anderen eingangsseitigen Anschluss U_{IN1} und diesem Element GT sind dagegen ein Ohm'scher Widerstand R1, ein Element mit positiven Temperaturkoeffizienten (PTC-Element) PCT sowie zwei (optionale) Zenerdioden D1, D2 in Serie geschaltet.

Die Ausgangssignale des Elements GT zur galvanischen Trennung werden einem Komparator KOMP zugeführt. Der Komparator KOMP vergleicht das Ausgangssignal des Elements GT zur galvanischen Trennung (Eingang 3 des Komparators) mit einem an dem invertierten Eingang 2 anliegenden Referenz- oder Schwellenwertsignals des Komparators KOMP. Abhängig von dem Vergleich gibt der Komparator KOMP dann das Logiksignal OUT beispielsweise an den Controller weiter.

Die Komparatorschwelle, d.h. das Spannungssignal, das an dem invertierten Eingang 2 des Komparators KOMP anliegt, hängt dabei durch eine entsprechende Schaltung von Ohm'schen Widerständen R8 und R9 von dem ausgangsseitigen Strom des Elements GT zur galvanischen Trennung ab. Je höher der durch das Element GT zur galvanischen Trennung fließende ausgangsseitige Strom ist, desto niedriger ist der Spannungsabfall an dem Ohm'schen Widerstand R8 und desto niedriger ist die Komparatorschwelle entsprechend der an dem invertierten Eingang 2 anliegenden Spannung.

Für den Fall, dass daher an den eingangsseitigen Anschlüssen U_{IN1}, U_{IN2} der Schnittstelleneinrichtung Digitalsignale mit einem verhältnismäßig niedrigen Pegel anliegen, ist entsprechend der Strom durch das Element zur galvanischen Trennung GT ausgangsseitig entsprechend niedrig, so dass auch die Komparatorschwelle entsprechend hoch ist. Wenn andererseits Netzspannungssignale an den eingangsseitigen Anschlüssen U_{IN1}, U_{IN2} anliegen, ist die Komparatorschwelle automatisch dementsprechend niedriger gewählt.

Bei dem Aufbau der in der Figur dargestellten erfindungsgemässen Schnittstellenvorrichtung wurde insbesondere darauf geachtet, dass verhältnismässig wenige und kostengünstige Bauteile verwendet werden. Wie im folgenden erläutert werden wird, weist die erfindungsgemässe Schnittstellenvorrichtung dennoch die erforderliche Festigkeit gegenüber einer dauerhaft anliegenden Netzspannung auf sowie gegenüber Spannungsspitzen (Bursts) auf.

Die erfindungsgemässe Schnittstelle ist dabei derart ausgelegt, dass der eingangsseitige Optokopplerstrom einen Spitzenstromwert von 1 Ampere (auch bei Anliegen einer Netzspannung) nicht überschreitet. Dauerhaft, d.h. im stationären Zustand, soll der eingangsseitige Optokopplerstrom einen Wert von bspw. 50 mA RMS nicht überschreiten.

Andererseits muss der Strom durch den Optokoppler bei Anliegen eines Hochpegel-Digitalsignals bspw. wenigstens 400 µA betragen. Die genannten Werte sind als Beispiel zu verstehen und hängen natürlich vom gewählten Optokopplertyp ab.

Der Ohm'sche Widerstand R1 muss bei Anliegen einer Netzspannung so lang elektrische Energie in Wärme umsetzen, bis das PTC-Element sich erwärmt und in den hochohmigen Zustand übergeht, wodurch der Strom durch diesen Pfad wieder abfällt.

Andererseits, wenn bei Anliegen einer Netzspannung das PTC-Element in den hochohmigen Zustand (beispielsweise von 3 kOhm auf 100 kOhm innerhalb eines Zeitraums von wenigen Sekunden) übergeht, muss weiterhin der oben bereits erwähnte Minimalstrom von etwa 400 µA durch den Optokoppler fließen, damit der folgende Komparator sicher den logischen Zustand "Hoch" erfasst. Wenn das PTC-Element schließlich in den hochohmigen Zustand übergegangen ist, sinkt entsprechend der Strom bspw. auf einen Wert von 20-30mA und die Verlustleistung der Schnittstelle auf einen Wert von etwa 1,4 Watt, wobei durch diese Strombegrenzungswirkung des PTC-Elements der Vorschaltwiderstand R1 geschont wird.

Die Zenerdioden D1, D2 dienen zur Definition des Low-Pegels des Digitalsignals. Wen beispielsweise die Durchbruchspannung der Zenerdioden etwa 4,7V beträgt und gleichzeitig die Flussspannung des Optokopplers etwa 1,0 V beträgt, wird ein Digitalspannungssignal an den Eingängen U_{IN1}, U_{IN2} unter etwa 9,5 V sicher als logisch "0" interpretiert. Die Zenerdioden sind daher abhängig von den Pegeln des Digitalsignals zu dimensionieren bzw. bei entsprechender Pegelwahl auch weglassbar.

Die Erfindung weist somit folgende Vorteile auf:
- Die erfindungsgemässe Schnittstellenvorrichtung ist fest gegenüber einer dauerhaft anliegenden Netzspannung wie auch gegenüber Spannungsspitzen,
- Die Erfindung kommt mit nur zwei eingangsseitigen Anschlüssen für Digitalsignale oder wahlweise für Netzspannungssignale aus, und
- die Schnittstelle ist mit wenigen, verhältnismässig günstigen Bauteilen aufgebaut.

## Patentansprüche

1. Schnittstelle zur Ansteuerung von elektronischen Geräten, insbesondere Lampenbetriebsgeräten oder LED-Betriebsgeräten, mit zwei eingangsseitigen Anschlüssen (U_{IN1}, U_{IN2}), an die wahlweise ein Digitalsignal oder ein Netzspannungssignal angelegt werden kann, wobei
- die beiden eingangsseitigen Anschlüsse (U_{IN1}, U_{IN2}) mit einem Optokoppler (GT) verbunden sind, und
- ein Ohm'scher Widerstand (R1) und ein PTC-Element (PTC) in Serie zwischen einem der beiden eingangsseitigen Anschlüsse (U_{IN1}) und dem Optokoppler (GT) geschaltet ist,
wobei der Ohm'sche Widerstand (R1) und das PTC-Element (PTC) derart bemessen sind, dass
- bei Anliegen einer Spannung an den eingangsseitigen Anschlüssen entsprechend einem Digitalsignal ein Strom fliesst, der die Ansprechschwelle des Optokopplers (GT) überschreitet,
- bei Anliegen einer Netzspannung an den eingangsseitigen Anschlüssen im warmen hochohmigen Zustand des PTC-Elements (PTC) der Strom durch den Optokoppler (GT) die Ansprechschwelle des Optokopplers überschreitet, und
- bei Anliegen einer Netzspannung an den eingangsseitigen Anschlüssen im warmen hochohmigen Zustand des PTC-Elements (PTC) der Strom durch den Optokoppler (GT) nicht den maximal zulässigen Dauerstrom überschreitet.

2. Schnittstelle nach einem der vorhergehenden Ansprüche,
**dadurch gekennzeichnet,**
**dass** seriell zu dem Ohmschen Widerstand (R₁) und dem Kaltleiterwiderstand (PTC) eine Serienschaltung zweier Zener-Dioden (D₁, D₂) mit betragsgleichen Temperaturkoeffizienten verschiedener Vorzeichen geschaltet ist.

3. Schnittstelle nach einem der vorhergehenden Ansprüche,
**dadurch gekennzeichnet, dass**
die am invertierenden Eingang des Komparators (KOMP) anliegende Schwellenspannung (*U₂*) über einen Schleifkontakt eines Potentiometerwiderstands (*R*₉) in Abhängigkeit von einer als Versorgungsspannung dieses Komparators (KOMP) dienenden Gleichspannung (*U_{cc}*) einstellbar ist.

4. Schnittstelle nach einem der vorhergehenden Ansprüche,
**dadurch gekennzeichnet, dass**
die am nicht-invertierenden Eingang des Komparators (KOMP) anliegende Spannung (*U*_{*a*,*GT*}) eine Funktion des Stroms (*I*_{*a*,*GT*}) am Ausgang des Optokopplers (GT) ist.

5. Schnittstelle nach einem der vorhergehenden Ansprüche,
**dadurch gekennzeichnet,**
**dass** die Schnittstelle für einen bidirektionalen Datenverkehr ausgelegt ist, um Daten von einem angeschlossenen Gerät mittels der beiden eingangsseitigen Anschlüsse (IN1, IN2) an eine Busleitung auszugeben.

6. Lampenbetriebsgerät oder Betriebsgerät für wenigstens eine Licht emittierende Diode, aufweisend eine Schnittstelle nach einem der vorhergehenden Ansprüche

7. Verfahren zur Auslegung einer Schnittstelle zur Ansteuerung von elektronischen Geräten derart, dass wahlweise mittels eines an dieselben eingangsseitigen Anschlüsse der Schnittstelle angelegten Digitalsignals oder eines Netzspannungssignals eine Ansteuerung des elektronischen Geräts erfolgt, wobei
- die beiden eingangsseitigen Anschlüsse (U_{IN1}, U_{IN2}) mit einem Optokoppler (GT) verbunden sind, und
- ein Ohm'scher Widerstand (R1) und ein PTC-Element (PTC) in Serie zwischen einem der beiden eingangsseitigen Anschlüsse (U_{IN1}) und dem Optokoppler (GT) geschaltet ist,
wobei der Ohm'sche Widerstand (R1) und das PTC-Element (PTC) derart ausgelegt wird, dass
- bei Anliegen einer Spannung an den eingangsseitigen Anschlüssen entsprechend einem Digitalsignal ein Strom fliesst, der die Ansprechschwelle des Optokopplers (GT) überschreitet,
- bei Anliegen einer Netzspannung an den eingangsseitigen Anschlüssen im warmen hochohmigen Zustand des PTC-Elements (PTC) der Strom durch den Optokoppler (GT) die Ansprechschwelle des Optokopplers überschreitet, und
- bei Anliegen einer Netzspannung an den eingangsseitigen Anschlüssen im warmen hochohmigen Zustand des PTC-Elements (PTC) der Strom durch den Optokoppler (GT) nicht den maximal zulässigen Dauerstrom überschreitet.

## Claims

1. Interface for control of electronic devices, in particular lamp operating devices or LED operating devices, having two input-side terminals (U_{IN1}, U_{IN2}), to which selectively a digital signal or a mains voltage signal can be applied, wherein
- the two input-side terminals (U_{IN1}, U_{IN2}) are connected to an optocoupler(GT), and
- an ohmic resistance (R1) and a PTC element (PTC) are connected in series between one of the two input-side terminals (U_{IN1}) and the optocoupler (GT),
wherein the ohmic resistance (R1) and the PTC element (PTC) are so dimensioned that
- upon application of a voltage corresponding to a digital signal to the input-side terminals there flows a current which exceeds the response threshold of the optocoupler (GT),
- upon application of a mains voltage to the input-side terminals in the warm high-impedance condition of the PTC element (PTC) the current through the optocoupler (GT) exceeds the response threshold of the optocoupler (GT)
- upon application of a mains voltage to the input-side terminals in the warm high-impedance condition of the PTC element (PTC) the current through the optocoupler (GT) does not exceed the maximum permitted persistent current.

2. Interface in accordance with any preceding claim, **characterised in that** there is connected in series to the ohmic resistance (R₁) and the positive temperature coefficient resistance (PTC) a series connection of two Zener diodes (D₁, D₂) with temperature coefficients equal in magnitude, of different sign.

3. Interface in accordance with any preceding claim, **characterised in that** the threshold voltage (U₂) applied at the inverting input of the comparator (KOMP) is adjustable via a slider contact of a potentiometer resistance (R₉) in dependence upon a d.c. voltage (U_{cc}) serving as a supply voltage of this comparator (KOMP).

4. Interface in accordance with any preceding claim, **characterised in that** the voltage (U_{a,GT}) at the noninverting input of the comparator (KOMP) is a function of the current (I_{a,GT}) at the output of the optocoupler (GT).

5. Interface in accordance with any preceding claim, **characterised in that** the interface is configured for bi-directional data traffic, to issue data from an attached device by means of the two input-side terminals (INI, IN2) to a bus line.

6. Lamp operating device or operating device for at least one light emitting diode, having an interface in accordance with any preceding claim.

7. Method for configuring an interface for controlling electronic devices such that selectively by means of a digital signal applied to the same input-side terminal of the interface or a mains voltage signal a control of the electronic device is effected, wherein
- the two input-side terminals (U_{IN1}, U_{IN2}) are connected to an optocoupler(GT), and
- an ohmic resistance (R1) and a PTC element (PTC) are connected in series between one of the two input-side connections (U_{IN1}) and the optocoupler (GT),
wherein the ohmic resistance (R1) and the PTC element (PTC) are so dimensioned that
- upon application of a voltage corresponding to a digital signal to the input-side terminals there flows a current which exceeds the response threshold of the optocoupler (GT),
- upon application of a mains voltage to the input-side terminals in the warm high-impedance condition of the PTC element (PTC) the current through the optocoupler (GT) exceeds the response threshold of the optocoupler (GT)
- upon application of a mains voltage to the input-side terminals in the warm high-impedance condition of the PTC element (PTC) the current through the optocoupler (GT) does not exceed the maximum permitted persistent current.

## Revendications

1. Interface pour l'activation d'appareils électroniques, en particulier d'appareils de service à lampe ou d'appareils de service à diodes électroluminescentes, comprenant deux branchements (U_{IN1}, U_{IN2}) côté entrée sur lesquels on peut appliquer au choix un signal numérique ou un signal de tension de réseau, dans lequel :
- les deux branchements (U_{IN1}, U_{IN2}) côté entrée sont liés à un optocoupleur (GT) et,
- une résistance ohmique (R1) et un élément PTC (PTC) sont branchés en série entre l'un des deux branchements (U_{IN1}) côté entrée et l'optocoupleur (GT),
la résistance ohmique (R1) et l'élément PTC (PTC) étant dimensionnés de telle sorte que,
- en cas d'application d'une tension sur les branchements côté entrée en fonction d'un signal numérique, il circule un courant qui dépasse le seuil de déclenchement de l'optocoupleur (GT),
- en cas d'application d'une tension de réseau sur les branchements côté entrée, lorsque l'élément PTC (PTC) est dans l'état chaud et à haute impédance, le courant traversant l'optocoupleur (GT) dépasse le seuil de déclenchement de l'optocoupleur, et
- en cas d'application d'une tension de réseau sur les branchements côté entrée, lorsque l'élément PTC (PTC) est dans l'état chaud et à haute impédance, le courant traversant l'optocoupleur (GT) ne dépasse pas le courant permanent maximal autorisé.

2. Interface selon l'une quelconque des revendications précédentes,
**caractérisée en ce que**
un montage en série de deux diodes de Zener (D₁, D₂) avec des coefficients de température de même valeur et de signe différent est branché en série avec la résistance ohmique (R₁) et la résistance à coefficient de température positif (PTC).

3. Interface selon l'une des revendications précédentes,
**caractérisée en ce que**
la tension de seuil (U₂) s'appliquant sur l'entrée inverseuse du comparateur (KOMP) peut être réglée au moyen d'un contact à frottement d'une résistance de potentiomètre (R₉) en fonction d'une tension continue (U_{cc}) servant à la tension d'alimentation de ce comparateur (KOMP).

4. Interface selon l'une des revendications précédentes,
**caractérisée en ce que**
la tension (Uₐ, _{GT}) s'appliquant sur l'entrée non l'inverseuse du comparateur (KOMP) est une fonction du courant (Iₐ, _{GT}) à la sortie de l'optocoupleur (GT).

5. interface selon l'une des revendications précédentes,
**caractérisée en ce que**
l'interface est conçue pour un trafic de données bidirectionnel, afin de délivrer dés données d'un appareil raccordé au moyen des deux branchements (IN1, IN2) côté entrée à une conduite de bus.

6. Appareil de service à lampe ou appareil de service pour au moins une diode émettrice de lumière, présentant une interface selon l'une des revendications précédentes.

7. Procédé pour la conception d'une interface pour l'activation d'appareils électroniques de telle sorte qu'une activation de l'appareil électronique s'effectue au choix au moyen d'un signal numérique appliqué sur les mêmes branchements côté entrée de l'interface ou d'un signal de tension de réseau, dans lequel :
- les deux branchements (U_{IN1}, U_{IN2}) côté entrée étant reliés à un optocoupleur (GT) et
- une résistance ohmique (R1) et un élément PTC (PTC) sont branchés en série entre l'un des deux branchements (U_{IN1}) côté entrée et l'optocoupleur (GT),
la résistance ohmique (R1) et l'élément PTC (PTC) étant conçus de telle sorte que
- en cas d'application d'une tension sur les branchements côté entrée en fonction d'un signal numérique, il circule un courant qui dépasse le seuil de déclenchement de l'optocoupleur (GT),
- en cas d'application d'une tension de réseau sur les branchements côté entrée, lorsque l'élément PTC (PTC) est dans l'état chaud et à haute impédance, le courant traversant l'optocoupleur (GT) dépasse le seuil de déclenchement de l'optocoupleur, et
- en cas d'application d'une tension de secteur sur les branchements côté entrée, lorsque l'élément PTC (PTC) est dans l'état chaud et à haute impédance, le courant traversant l'optocoupleur (GT) ne dépasse pas le courant permanent maximal autorisé.
